# EUROPÄISCHE PATENTANMELDUNG

(11) **EP 4 279 937 A2**
(43) Veröffentlichungstag der Anmeldung: **22.11.2023**
(21) Anmeldenummer: 23170068.3
(22) Anmeldetag: 26.04.2023
(51) Int. Cl.: G01R 31/59

(54) **VORRICHTUNG ZUR PRÜFUNG UND/ODER MONTAGE EINES KABELSATZES, VERFAHREN ZUR WARTUNG EINER SOLCHEN VORRICHTUNG, ROBOTER UND COMPUTERPROGRAMM**

(30) Priorität: 16.05.2022 DE 102022204788
(71) Anmelder: LEONI Bordnetz-Systeme GmbH, 97318 Kitzingen (DE); Leoni Wiring Systems Tunisia Sarl, 4013 M'saken-Sousse (TN)
(72) Erfinder: EGBERS, Andreas, 36272 Niederaula (DE); ELTAIEF, Kilani, 4021 Kalaa Sghira (TN)
(74) Vertreter: FDST Patentanwälte

(57) **Zusammenfassung**

Es wird eine Vorrichtung (2) zur Prüfung und/oder Montage eines Kabelsatzes (K) angegeben, mit einer Prüfungs- und/oder Montagevorrichtung (3) und mit einem Roboter (8), zur Wartung der Prüfungs- und/oder Montagevorrichtung. Weiter werden ein Roboter (8) für eine solche Vorrichtung (2), ein Verfahren zur Wartung einer solchen Vorrichtung (2) sowie ein Computerprogramm angegeben, wobei die Prüfungs- und/oder Montagevorrichtung (3) eine Montagefläche (4) aufweist, welche zumindest eine Schnittstelle (6) aufweist, um den Kabelsatz (K) zu prüfen und/oder zu halten.

## Beschreibung

Die Erfindung betrifft eine Vorrichtung zur Prüfung und/oder Montage eines Kabelsatzes, ein Verfahren zur Wartung einer solchen Vorrichtung, einen Roboter und ein entsprechendes Computerprogramm.

Ein Kabelsatz ist zusammengesetzt aus mehreren Kabeln und/oder Leitungen und weist gegebenenfalls zusätzlich noch Medienschläuche und dergleichen auf. Gegebenenfalls sind zusätzlich noch ein oder mehrere Funktionsmodule vorhanden, um anwendungsabhängige Funktionen zu implementieren. Ein Kabelsatz weist zudem regelmäßig entsprechende Steckverbinder am Ende oder entlang der Kabel und Leitungen auf, um den Kabelsatz in ein Gesamtsystem, z.B. ein Fahrzeug, zu integrieren. Ein Kabelsatz wird beispielsweise in einem Bordnetz eines Fahrzeugs verwendet.

Während oder nach der Herstellung eines einzelnen Kabelsatzes ist es zweckmäßig, diesen zu prüfen, um dessen ordnungsgemäße Funktionalität sicherzustellen und gegebenenfalls vorhandene Defekte zu beheben, bevor der Kabelsatz dann in ein Gesamtsystem integriert wird. Zur Prüfung wird beispielsweise ein sogenannter Testtisch verwendet, in welchen mehrere Prüfmodule integriert sind. Der Kabelsatz wird an die diversen Prüfmodule angeschlossen und dann mittels dieser geprüft. Beispielsweise werden mittels der Prüfmodule elektrische Eigenschaften wie Strom, Spannung, Widerstand etc. entlang einzelner oder mehrerer Kabel und Leitungen des Kabelsatzes gemessen. Die Prüfung eines Kabelsatzes erfordert eine einwandfreie Funktionalität des Testtisches, welcher daher regelmäßig gewartet werden muss. Gleiches gilt analog für ein Montagebrett oder dergleichen, auf welchem der Kabelsatz bei dessen Herstellung z.B. mittels Halterungen gehalten wird. Im Rahmen einer Wartung werden beispielsweise die Prüfmodule oder Halterungen gereinigt und/oder auf Defekte überprüft. Grundsätzlich ist es möglich, den Testtisch durch einen Techniker manuell zu warten. Dies ist jedoch zeitaufwendig und fehleranfällig.

Es wird verwiesen auf DE 10 2016 111 521 A1, DE 10 2015 011 822 A1, DE 10 2016 217 564 A1, EP 3 614 821 A1 und DE 10 2011 014 801 A1.

Vor diesem Hintergrund ist es eine Aufgabe der Erfindung, die Wartung einer Vorrichtung zur Prüfung und/oder Montage eines Kabelsatzes zu verbessern. Die Wartung soll möglichst automatisiert erfolgen. Hierzu sollen eine entsprechende Vorrichtung, ein Roboter, ein Verfahren und ein Computerprogrammprodukt angegeben werden.

Die Aufgabe wird erfindungsgemäß gelöst durch eine Vorrichtung mit den Merkmalen gemäß Anspruch 1, durch einen Roboter mit den Merkmalen gemäß Anspruch 13, ein Verfahren mit den Merkmalen gemäß Anspruch 14 sowie durch ein Computerprogramm mit den Merkmalen gemäß Anspruch 15. Vorteilhafte Ausführungen, Weiterbildungen und Varianten sind Gegenstand der Unteransprüche. Die Ausführungen im Zusammenhang mit der Vorrichtung gelten sinngemäß auch für den Roboter, das Verfahren sowie das Computerprogramm und umgekehrt. Sofern nachfolgend Schritte des Verfahrens beschrieben sind, ergeben sich zweckmäßige Ausgestaltungen für die Vorrichtung und den Roboter dadurch, dass diese/dieser ausgebildet ist, einen oder mehrere dieser Schritte auszuführen. Hierfür weist die Vorrichtung/der Roboter insbesondere eine entsprechend ausgebildete Steuereinheit auf.

Ein Kerngedanke der Erfindung ist insbesondere die Verwendung eines Roboters zur möglichst weitgehenden Automatisierung einer Wartung einer Prüfungs- und/oder Montagevorrichtung, welche zur Prüfung und/oder Montage eines Kabelsatzes verwendet wird. Die Wartung umfasst vorzugsweise eine Reinigung, eine Überprüfung (z.B. Fehlerdiagnose oder Inspektion) oder eine Konfiguration der Prüfungs- und/oder Montagevorrichtung oder eine Kombination hiervon. Die Wartung ist insbesondere definiert durch eine Anzahl an Wartungsaufgaben, welche im Rahmen der Wartung abzuarbeiten sind. Grundsätzlich ist es möglich die Wartung manuell durchzuführen, dies ist jedoch zeitaufwendig und aufgrund des menschlichen Faktors auch fehlerbehaftet. Da eine Wartung zudem wiederkehrend nötig ist, ist diese insgesamt sehr personalintensiv. Sofern bei der Wartung bestimmte Werkzeuge eingesetzt werden, erfolgt deren Bedienung üblicherweise manuell. Eine nicht korrekte Wartung kann jederzeit zu einem längeren Stillstand der eigentlichen Produktion (Montage und/oder Prüfung von Kabelsätzen) und damit zu hohen Kosten führen. Vorliegend wird daher der Prozess der Wartung soweit wie möglich automatisiert, vorzugsweise werden einem Techniker nur noch etwaige automatisiert gefundene Fehler etc. angezeigt, sodass sich der manuelle Anteil der Wartung auf ein Minimum reduziert. Dies führt insbesondere zu einer Zeitersparnis und daneben noch zu anderen Vorteilen.

Eine erfindungsgemäße Vorrichtung ist zur Prüfung und/oder Montage eines Kabelsatzes ausgebildet. Hierzu weist die Vorrichtung eine Prüfungs- und/oder Montagevorrichtung auf. Die Vorrichtung, speziell die Prüfungs- und/oder Montagevorrichtung, weist eine Montagefläche auf, welche zumindest eine Schnittstelle aufweist, z.B. ein Prüfmodul, einen Sensor, einen Steckverbinder, eine Gabel, einen Clip, eine Halterung oder dergleichen, um den Kabelsatz zu prüfen und/oder zu halten. Die Schnittstelle ist geeigneterweise eine elektrische, mechanische, hydraulische oder optische Schnittstelle oder eine Kombination hiervon. Die Schnittstelle wird auch als Interaktionselement bezeichnet. Typischerweise weist die Montagefläche eine Vielzahl an Schnittstellen auf, um den Kabelsatz an unterschiedlichen Stellen zu prüfen und/oder zu halten. Weiter weist die Vorrichtung einen Roboter auf, zur vorteilhaft automatisierten Wartung der Montagefläche, genauer gesagt zur Wartung der Schnittstelle. Nachfolgend wird ohne Beschränkung der Allgemeinheit davon ausgegangen, dass die Montagefläche mehrere Schnittstellen aufweist, welche auch nicht zwingend gleichartig ausgebildet sind, die Ausführungen gelten aber auch für eine Montagefläche mit lediglich einer Schnittstelle.

Nachfolgend wird ohne Beschränkung der Allgemeinheit von einer Vorrichtung mit einer Montagefläche ausgegangen, die Erfindung ist aber gleichermaßen auf Vorrichtungen ohne Montagefläche anwendbar, z.B. weist die Prüfungs- und/oder Montagevorrichtung einen Werkzeugkopf mit einem Werkzeug auf, welches dann von dem Roboter gewartet wird.

Durch den Roboter und die damit automatisierte Wartung ergeben sich diverse Vorteile, unter anderem eine grundsätzlich vorteilhafte Prozessautomatisierung sowie eine Zeitersparnis und Effizienzsteigerung im Vergleich zu einer manuellen Wartung. Darüber hinaus ist die Wartung durch den Roboter regelmäßig gründlicher, sodass z. B. Kurzschlüsse oder verschmutzte Steckverbinder am Kabelsatz oder andere Fehler besser vermieden werden. Die Wartung ist zudem vorteilhaft unabhängig von der Arbeitszeit eines Technikers möglich, z.B. in Pausenzeiten. Auch werden Unterbrechungen in der Herstellung (Prüfung und/oder Montage) von Kabelsätzen vorteilhaft reduziert.

Der Kabelsatz ist zusammengesetzt aus mehreren Kabeln und/oder Leitungen und weist gegebenenfalls zusätzlich noch Medienschläuche, z.B. für Druckluft, oder ähnliches auf. Optional weist der Kabelsatz zusätzlich noch ein oder mehrere Funktionsmodule auf, um anwendungsabhängige Funktionen zu implementieren, z.B. Schalter, Wandler, Sensoren etc. Der Kabelsatz weist geeigneterweise entsprechende Steckverbinder am Ende oder entlang der Kabel, Leitungen oder Medienschläuche auf, um den Kabelsatz in ein Gesamtsystem, z.B. ein Fahrzeug, zu integrieren. Der Kabelsatz wird beispielsweise in einem Bordnetz eines Fahrzeugs verwendet. Die genaue Ausgestaltung des Kabelsatzes ist vorliegend jedoch von untergeordneter Bedeutung. Tatsächlich ist der Kabelsatz während der Wartung der Montagefläche üblicherweise nicht präsent und spielt für die Wartung nur insofern eine Rolle, als dass der Kabelsatz die konkrete Ausgestaltung der Montagefläche definiert. Zur Prüfung und/oder Halterung wird der Kabelsatz mit den Schnittstellen der Montagefläche gekoppelt (z.B. befestigt, gesteckt, geclipst, eingelegt, aufgelegt, angelegt, positioniert oder dergleichen). Der Kabelsatz selbst ist somit nicht zwingend Gegenstand der hier beschriebenen Wartung, diese betrifft insbesondere ausschließlich die Montagefläche an sich und speziell deren Schnittstellen. Die Prüfung und/oder Montage des Kabelsatzes unter Verwendung der Montagefläche erfolgt üblicherweise durch einen Techniker und ist vorliegend ebenfalls nicht Gegenstand.

Die Ausgestaltung und Anordnung der Schnittstellen ist abhängig von der konkreten Ausgestaltung des Kabelsatzes. Die Schnittstellen sind regelmäßig über die Montagefläche verteilt angeordnet, sodass der Kabelsatz bei dessen Prüfung/Halterung an verschiedenen Stellen mit der Montagefläche gekoppelt ist.

Bevorzugterweise ist die Montagefläche eine Oberfläche eines Testtisches (z.B. ein "technical control table", kurz TCT) oder eines Montagebretts (z.B. Verlegebrett). Der Testtisch beziehungsweise das Montagebrett sind selbst ein Teil der Vorrichtung. Ein Testtisch dient vorrangig zur z.B. mechanischen und/oder elektrischen Prüfung eines an sich fertig montierten Kabelsatzes, ein Montagebrett dient hingegen vorrangig zur Montage eines Kabelsatzes. Mischformen von Testtisch und Montagebrett sind grundsätzlich auch möglich und geeignet. Auch ist die hier beschriebene Erfindung anwendbar auf andere Vorrichtungen, so ist in einer bevorzugten Ausgestaltung die Prüfungs- und/oder Montagevorrichtung ein Ultraschallschweißgerät. Nachfolgend wird ohne Beschränkung der Allgemeinheit von einem Testtisch oder Montagebrett ausgegangen.

In einer geeigneten Ausgestaltung ist die Schnittstelle eine Halterung, zum Halten des Kabelsatzes, und der Roboter ist derart ausgebildet, dass dieser im Rahmen der Wartung die Halterung überprüft. Diese Überprüfung der Halterung stellt eine Wartungsaufgabe dar. Die Halterung realisiert eine mechanische Verbindung des Kabelsatzes mit der Montagefläche. Die Verbindung ist insbesondere lösbar. Eine Halterung ist regelmäßig Teil eines Montagebretts, aber auch für einen Testtisch geeignet. Die Halterung ist in einer geeigneten Ausgestaltung ein Clip, auch als Halteclip bezeichnet, in welchen ein Teil des Kabelsatzes eingeclipst wird. Ebenfalls geeignet ist eine Halterung, welche als Steckverbinder ausgebildet ist und optional zusätzlich eine elektrische Anbindung des Kabelsatzes an die Montagefläche realisiert. Auch geeignet ist eine Halterung, welche als Kabelkanal ausgebildet ist, zur Führung eines Teils des Kabelsatzes entlang eines bestimmten Pfads, im Gegensatz zu einem Clip, welcher den Kabelsatz lediglich punktuell hält.

Die Überprüfung der Halterung und allgemein jeglicher Schnittstelle durch den Roboter umfasst allgemein die Erkennung eines Ist-Zustands der Schnittstelle und einen Vergleich des Ist-Zustands mit einem Soll-Zustand sowie die Ausgabe eines Hinweises z.B. an einen Techniker, dass der Ist-Zustand mit dem Soll-Zustand übereinstimmt oder nicht, beispielsweise wird ein Bildvergleich durchgeführt oder von der Schnittstelle ein Kontrollsignal empfangen und mit einem Referenzsignal verglichen oder ein Bild oder Kontrollsignal von der Schnittstelle werden nach bestimmten Merkmalen abgesucht. Die Bestimmung des Ist-Zustands ist zunächst nebensächlich.

Mittels der Überprüfung wird vorzugsweise ermittelt, ob die Schnittstelle ordnungsgemäß beschaffen ist und/oder ordnungsgemäß funktioniert. Auf diese Weise wird vom Roboter beispielsweise eine falsche Ausrichtung und/oder eine Beschädigung der Schnittstelle erkannt, z.B. ein Abriss eines Teils der Halterung aufgrund einer unsachgemäßen Handhabung während einer vorangegangenen Montage. Alternativ oder zusätzlich wird vom Roboter überprüft, ob an einer gegebenen Position eine Schnittstelle eines bestimmten Typs installiert ist. Der Typ ist geeigneterweise durch eine Codierung an oder in der Nähe der Schnittstelle angegeben, z.B. eine Farbcodierung oder Beschriftung. Bei einer Halterung gibt die Codierung geeigneterweise eine Abrisskraft an, bei deren Erreichen die Halterung abbricht. Unterschiedliche Codierungen (z.B. unterschiedliche Farben) zeigen dann unterschiedliche Abrisskräfte an. Der Roboter erkennt nun die Codierung (Ist-Zustand) und vergleicht diese mit einer vorgesehenen Codierung (Soll-Zustand). Ist die erkannte Codierung inkorrekt, wird vom Roboter zweckmäßigerweise ein entsprechender Hinweis ausgegeben. Alternativ oder zusätzlich wird vom Roboter eine Funktion der Schnittstelle überprüft. In einer geeigneten Ausgestaltung gibt die Schnittstelle bei der Kopplung mit einem Kabelsatz ein Kontrollsignal aus. Um diese Funktion zu prüfen simuliert der Roboter die Kopplung und ist ausgebildet, das Kontrollsignal zu empfangen, z.B. mittels einer Antenne. Empfängt der Roboter das Kontrollsignal, ist die Funktion korrekt, andernfalls fehlerhaft, woraufhin dann ein entsprechender Hinweis ausgegeben wird.

In einer vorteilhaften Ausgestaltung weist die Schnittstelle einen Schalter auf, welcher durch Koppeln des Kabelsatzes mit der Schnittstelle auslösbar ist. Der Schalter ist beispielsweise ein mechanischer, elektrischer oder optischer Schalter, z.B. ein Taster oder Näherungssensor. Bei einer Kopplung mit einem Kabelsatz löst der Schalter aus und sendet ein Kontrollsignal aus. Dieses wird insbesondere bei der Prüfung und/oder Montage des Kabelsatzes genutzt. Beispielsweise lässt sich mit Hilfe eines empfangenen Kontrollsignals die Anwesenheit eines bestimmten Bauteils am Kabelsatz feststellen. Die korrekte Funktionsfähigkeit des Schalters, d.h. das Auslösen des Schalters und Aussenden des Kontrollsignals wird zweckmäßigerweise im Rahmen der Wartung durch den Roboter überprüft. Auch dies stellt eine mögliche Wartungsaufgabe dar. Entsprechend ist der Roboter ausgebildet, im Rahmen der Wartung den Schalter auszulösen und dadurch die Funktionsfähigkeit der Schnittstelle zu überprüfen. Analog zu den Ausführungen weiter oben betätigt der Roboter im Rahmen der Wartung den Schalter, d.h. löst diesen aus, und erwartet dann das Kontrollsignal. Dieses empfängt der Roboter beispielsweise über eine geeignete Antenne oder einen anderen Signaleingang. Die Schnittstelle ist beispielsweise eine Halterung oder ein Prüfmodul, welches mittels des Schalters die Anwesenheit eines Kabelsatzes prüft, speziell die Anwesenheit eines bestimmten Abschnitts oder Funktionsmoduls des Kabelsatzes. Zur Gewährleistung dieser Funktionalität wird der Schalter vom Roboter während der Wartung betätigt und damit eine Kopplung mit einem korrekt hergestellten Kabelsatz simuliert.

In einer geeigneten Ausgestaltung sind ein oder mehrere Schnittstellen vorhanden, welche jeweils als Prüfmodul ausgebildet sind und mit welchen bei der Prüfung des Kabelsatzes z.B. dessen Funktionalität im Gesamtsystem simuliert wird. Ein jeweiliges Prüfmodul misst beispielsweise einen elektrischen Parameter (Strom, Spannung, Widerstand, Dämpfung etc.) des Kabelsatzes oder prüft in Kombination mit einem anderen Prüfmodul eine Signalübertragung durch den Kabelsatz. Während der Wartung werden solche Schnittstellen nun durch den Roboter geprüft, indem der Roboter analog zu obigen Ausführungen die Präsenz eines Kabelsatzes simuliert und/oder indem der Roboter an der Schnittstelle eine oder mehrere geeignete Messungen vornimmt, um die korrekte Beschaffenheit und/oder Funktionsweise eines jeweiliges Prüfmoduls zu prüfen und gegebenenfalls einen Hinweis auf einen Defekt oder eine Fehlfunktion auszugeben. Auch dies stellt eine Wartungsaufgabe dar.

In einer vorteilhaften Ausgestaltung ist die Schnittstelle ein Platzhalter für ein Bauteil (d.h. insbesondere zur Simulation eines Bauteils) eines Gesamtsystems, in welches der Kabelsatz integrierbar ist. Darunter wird insbesondere verstanden, dass die Schnittstelle ein Bauteil des Gesamtsystems simuliert, nicht aber, dass das Bauteil des Gesamtsystems an die Schnittstelle angeschlossen wird. Vielmehr wird der Kabelsatz an die Schnittstelle angeschlossen, um die Interaktion des Kabelsatzes mit dem tatsächlich nicht-vorhandenen Bauteil zu simulieren. Mit anderen Worten: die Schnittstelle nimmt den Platz des Bauteils ein.

In einer bevorzugten Ausgestaltung ist der Roboter ausgebildet, im Rahmen der Wartung eine Konfiguration der Montagefläche zu unterstützen, indem der Roboter die Schnittstelle aktiviert oder identifiziert oder einem Bauteil des Kabelsatzes zuordnet oder eine Kombination hiervon. Alternativ oder zusätzlich wird die Konfiguration unterstützt, indem der Roboter die Schnittstelle einem Bauteil des Gesamtsystems zuordnet. Auch dies stellt eine Wartungsaufgabe dar. Bei dieser Ausgestaltung wird davon ausgegangen, dass die Schnittstellen der Montagefläche vor einer Prüfung/Montage des Kabelsatzes definiert werden müssen, um eine korrekte Zuordnung von Kontrollsignalen der Schnittstellen zu korrespondierenden Bauteilen des Kabelsatzes und/oder des Gesamtsystems sicherzustellen, in welches der Kabelsatz integriert werden soll. Mit anderen Worten: mittels der Konfiguration werden die Schnittstellen mit korrespondierenden Bauteilen des Kabelsatzes und/oder Gesamtsystems registriert. Beispielsweise ist die Schnittstelle ein Prüfmodul, welches die Spannung (welche bei der Prüfung an anderer Stelle in den Kabelsatz eingespeist wird) an einem bestimmten Stecker des Kabelsatzes messen soll, da diese Spannung bei bestimmungsgemäßer Verwendung an einem Bauteil, z.B. einem Verbraucher, des Gesamtsystems anliegen soll. Die Kontrollsignale werden von einem geeigneten Computer oder ähnlichem empfangen, dieser kennt jedoch anfangs noch nicht die Zuordnung der Kontrollsignale zu dem genannten Stecker. Diese Zuordnung wird nun im Rahmen der Konfiguration (und damit als Teil der Wartung der Montagefläche) mit Hilfe des Roboters erstellt. Dabei dient der Roboter entweder lediglich als Assistenz für einen Techniker, aktiviert beispielsweise die Schnittstellen der Reihe nach, um deren Kontrollsignale auszulösen, während der Techniker am Computer die dort empfangenen Kontrollsignale den entsprechenden Bauteilen zuordnet, hier beispielhaft das Kontrollsignal einer Schnittstelle für den genannten Stecker des Kabelsatzes zu ebenjenem Stecker. Alternativ führt der Roboter die Konfiguration vollständig selbsttätig durch, indem der Roboter einerseits die Schnittstellen nacheinander auslöst und die entsprechenden Kontrollsignale empfängt und zugleich das zugehörige Bauteil identifiziert, z.B. indem eine entsprechende Codierung der Schnittstelle - insbesondere wie oben beschrieben - ausgelesen wird, sodass dann der Roboter das Kontrollsignal dem entsprechenden Bauteil zuordnet. Gegebenenfalls wird auch eine Codierung des Bauteils ausgelesen, um dieses einer entsprechenden Schnittstelle zuzuordnen. Beispielsweise sind Bezeichnungen der Bauteile jeweils als Beschriftung an einem jeweiligen Bauteil und/oder neben einer jeweiligen Schnittstelle angebracht. Der Roboter verknüpft dann die Codierung mit dem Kontrollsignal und führt somit die Konfiguration aus. Die vorgenannte Zuordnung, d.h. die dabei gewonnen Daten, wird beispielsweise als Liste an den Techniker oder den Computer ausgegeben und dann bei der Prüfung/Montage des Kabelsatzes verwendet.

Wie oben angedeutet, dient die Konfiguration in einer geeigneten Ausgestaltung zur Zuordnung eines Kontrollsignals von einer Schnittstelle zu einem entsprechenden Bauteil des Kabelsatzes. Zweckmäßigerweise erkennt der Roboter zunächst das Bauteil, für welches die jeweilige Schnittstelle vorgesehen ist. Hierzu ist geeigneterweise entweder der Kabelsatz mit allen relevanten Bauteilen bereits an/auf der Montagefläche montiert, um die Bauteile im Original erkennen zu können, oder auf der Montagefläche sind geeignete Kennzeichnungen angebracht (z.B. aufgeklebt oder aufgedruckt), welcher der Roboter dann erkennt, bevor dieser mit die Schnittstelle aktiviert, um von dieser das Kontrollsignal aussenden zu lassen. Anschließend nimmt der Roboter die Zuordnung vor und verknüpft dadurch die Schnittstelle mit dem zugehörigen Bauteil. Auf diese Weise erzeugt der Roboter eine Referenzliste, welche anschließend z.B. an einen Computer übermittelt wird.

In einer vorteilhaften Ausgestaltung weist die Schnittstelle zumindest einen elektrischen Anschluss auf, zum Anschließen des Kabelsatzes, und der Roboter ist ausgebildet, im Rahmen der Wartung der Montagefläche den elektrischen Anschluss zu Reinigen oder zu Überprüfen oder beides. Auch dies stellt eine mögliche Wartungsaufgabe dar. Der elektrische Anschluss der Schnittstelle dient zum elektrischen Anschließen des Kabelsatzes, z.B. um an diesem einen elektrischen Parameter zu messen. Die Reinigung ist beispielsweise eine mechanische oder chemische Reinigung, in einer besonders bevorzugten Ausgestaltung umfasst die Reinigung ein Absaugen insbesondere von Verschmutzungen und/oder Fremdkörpern. Die Überprüfung umfasst beispielsweise eine mechanische, elektrische oder optische Prüfung.

In einer vorteilhaften Ausgestaltung weist der Roboter einen Sauger (z.B. Vakuumsauger) auf, zum Reinigen allgemein der Prüfungs- und/oder Montagevorrichtung und speziell vorzugsweise zum Reinigen wenigstens eines Teils der Montagefläche im Rahmen der Wartung, z.B. zum Reinigen eines elektrischen Anschlusses einer Schnittstelle wie zuvor bereits im Zusammenhang mit einer mechanischen Reinigung eines elektrischen Anschlusses beschrieben. Der Sauger ist ein Werkzeug. Der Sauger weist in einer geeigneten Ausgestaltung eine Saugglocke oder einen Saugnapf auf, welcher/welche vorzugsweise aus einem elastischen Gummi hergestellt ist. Dies ermöglicht ein flexibles und schonendes Anschmiegen an eine zu reinigende Oberfläche.

Vorteilhafterweise weist der Roboter eine Empfangseinheit auf, geeigneterweise eine Antenne, zum Empfangen eines Kontrollsignals, insbesondere eines Kontrollsignals wie oben bereits beschrieben, welches während der Wartung von der Schnittstelle ausgesendet wird.

Vorteilhafterweise weist der Roboter als ein Werkzeug ein Federkraftmessgerät auf, zum Messen einer Federkraft (oder analog der Steifigkeit) eines elektrischen Anschlusses der Schnittstelle als eine Wartungsaufgabe im Rahmen der Wartung. Auch hierbei dient der elektrische Anschluss der Schnittstelle insbesondere zum elektrischen Anschließen des Kabelsatzes. Mit dem Federkraftmessgerät misst der Roboter eine Federkraft des elektrischen Anschlusses, welcher beispielsweise als Steckpin ausgebildet ist. Anhand der Federkraft erkennt der Roboter dann, ob der elektrische Anschluss ordnungsgemäß funktioniert oder einen Defekt aufweist. Die Messung der Federkraft stellt eine mechanische Überprüfung dar.

Für den Roboter sind vorliegend besonders die zwei nachfolgend beschriebenen Ausgestaltungen vorteilhaft: in einer ersten Ausgestaltung weist der Roboter einen Arbeitskopf und eine Translationseinheit auf, wobei der Arbeitskopf an der Translationseinheit angebracht ist und wobei die Translationseinheit vorzugsweise mit der Montagfläche verbunden ist und derart ausgebildet ist, dass mittels der Translationseinheit der Arbeitskopf an unterschiedliche Positionen der Prüfungs- und/oder Montagevorrichtung und speziell insbesondere an unterschiedliche Positionen der Montagefläche bewegbar ist. Der Roboter ist somit ein fester Bestandteil der Vorrichtung und mit der Montagefläche prinzipiell fest verbunden. Dies hat den Vorteil, dass die Position des Arbeitskopfs relativ zur Montagefläche prinzipbedingt bekannt ist. Die Translationseinheit ist beispielsweise eine dreiachsige Verschiebevorrichtung, z.B. mit drei paarweise senkrechten Translationsachsen nämlich je einer X-, Y- und Z-Achse. Die Montagefläche und die Translationseinheit bilden dann insbesondere einen XYZ-Tisch. Entlang der X- und Y-Achsen wird der Arbeitskopf parallel zur Montagefläche verschoben, eine Verschiebung entlang der Z-Achse ändert hingegen den Abstand des Arbeitskopfs zur Montagefläche. Die Z-Achse wird beispielsweise hydraulisch angetrieben, die X- und Y-Achsen werden beispielsweise elektrisch angetrieben. Am Arbeitskopf sind ein oder mehrere Werkzeuge anbringbar und je nach Wartungsaufgabe während der Wartung angebracht. Zweckmäßigerweise weist die Vorrichtung einen Werkzeugwechsler und/oder ein Werkzeugdepot auf, mittels welchen am Arbeitskopf je nach Bedarf ein geeignetes Werkzeug angebracht wird. Beispiele für Werkzeuge sind der bereits genannte Sauger und das bereits genannte Federkraftmessgerät. An einer jeweiligen Position ist insbesondere eine Schnittstelle angeordnet, sodass während der Wartung mit dem Arbeitskopf nacheinander verschiedene Positionen und somit die verschiedenen Schnittstellen angefahren werden, um dort eine Wartung vorzunehmen. Gegebenenfalls wird zwischendurch vom Arbeitskopf ein jeweils geeignetes Werkzeug aufgenommen.

In der zweiten Ausgestaltung ist der Roboter alternativ ein sogenannter Cobot, welcher insgesamt unabhängig von der Prüfungs- und/oder Montagevorrichtung und speziell vorzugsweise unabhängig von der Montagefläche positionierbar ist. Ein Cobot ist ein kollaborativer Roboter, welcher ausgebildet ist, mit einem oder mehreren Menschen, z.B. einem Techniker, gemeinsam zu arbeiten und welcher dabei nicht durch Schutzeinrichtungen von diesen Menschen getrennt ist. Der Cobot weist beispielsweise ein Fahrgestell auf oder ist auf einem fahrbaren Wagen montiert und ist somit zunächst unabhängig von der Montagefläche. Der Cobot enthält insbesondere sämtliche Hardware, welche zur Durchführung verschiedener Wartungsaufgaben im Rahmen der Wartung erforderlich sind. Zur Wartung der Montagefläche wird der Roboter an diese herangefahren, entweder selbsttätig oder durch einen Techniker. Zweckmäßigerweise weist der Cobot einen Arm mit einem Arbeitskopf auf, zur Halterung von Werkzeugen und dergleichen. Die Ausführungen weiter oben zum Arbeitskopf gelten analog auch für den Arbeitskopf des Cobots.

Mittels des Roboters, speziell mittels eines insbesondere transportablen Cobots, werden vorteilhaft die meisten Wartungsaufgaben an der Montagefläche automatisiert durchgeführt. Der Roboter handhabt alle bei der Wartung verwendeten Werkzeuge oder Hilfsmittel besser oder zumindest mit der gleichen Sorgfalt wie ein Techniker. Speziell bei Verwendung eines Cobots ist es möglich, diesen ohne aufwendige Sicherheitstechnik einzusetzen und sogar gemeinsam mit einem Menschen an der Montagefläche arbeiten zu lassen. Gleichzeitig schützt die für das kollaborative Arbeiten nötige Technik auch die zu wartende Montagefläche, da alle Bewegungen des Roboters auf Kollisionen etc. mittels entsprechender Sensoren überwacht werden.

Geeigneterweise weist der Roboter eine Kamera auf und ist ausgebildet, mittels der Kamera eine optische Überprüfung oder Identifikation der Schnittstelle durchzuführen oder um seine Position relativ zu der Schnittstelle zu bestimmen, um dieses zu warten, oder beides. Auch eine Ausgestaltung mit mehreren Kameras ist grundsätzlich denkbar und geeignet. Die Kamera ist geeigneterweise beweglich am Roboter angebracht, z.B. am Arbeitskopf des Roboters und zusätzlich oder alternativ zu einem Werkzeug. Die Kamera dient beispielsweise zur Aufnahme des Ist-Zustands für einen Bildvergleich als Teil einer optischen Überprüfung (z.B. zur Erkennung von Defekten) oder zur Aufnahme eines Bilds der Schnittstelle, um darin eine Codierung zu erkennen und somit die Schnittstelle zu identifizieren, wie oben bereits beschrieben wurde. Beispielsweise identifiziert der Roboter mittels der Kamera einzelne Schnittstellen wie Prüfmodule, Steckeraufnahmen, Sensoren oder andere Bauteile und/oder überprüft diese auf Beschädigungen. Beispielsweise überprüft der Roboter mittels der Kamera, ob alle Kontakte eines Steckers der Schnittstelle vorhanden sind und/oder ob einzelne oder mehrere dieser Kontakte beschädigt sind. Alternativ oder zusätzlich dient die Kamera zur Erkennung eines Aufbaus der Montagefläche oder zur Erkennung der Position der Schnittstellen oder deren Anordnung relativ zueinander. Speziell bei einem Cobot dient die Kamera zweckmäßigerweise zur Ausrichtung des Cobots relativ zur Montagefläche, beispielsweise anhand von Justiermarken der Montagefläche, welche mit der Kamera erkannt werden, um bestimmte Tätigkeiten während der Wartung auch korrekt ausführen zu können.

Vorzugsweise weist der Roboter ein Ausgabeelement auf und ist ausgebildet, hierüber einen Hinweis (auch als Meldung bezeichnet) auszugeben, wenn die Wartung abgeschlossen worden ist oder falls während der Wartung ein manuelles Eingreifen z.B. durch einen Techniker erforderlich ist. Der Hinweis ist insbesondere wenigstens einer der oben bereits an verschiedener Stelle genannten Hinweise. Grundsätzlich dient das Ausgabeelement somit zur Kommunikation des Roboters mit einem Techniker und/oder einem Computer. Über das Ausgabeelement wird dann insgesamt der Fortschritt oder der Status der Wartung ausgegeben. Das Ausgabeelement ist z.B. ein Lautsprecher oder ein Bildschirm oder einfach ein Sendemodul, welches den Hinweis an ein Empfangsmodul eines Zusatzgeräts sendet, z.B. an einen Computer oder an ein Smartphone eines Technikers.

Wie bereits angedeutet, ist es vorteilhaft die Montagefläche und speziell die Schnittstellen mittels eines Bildvergleichs zu warten. In einer geeigneten Ausgestaltung hierzu ist die Vorrichtung entsprechend ausgebildet, die Prüfungs- und/oder Montagevorrichtung und speziell insbesondere die Montagefläche mittels eines Bildvergleichs zu warten und hierzu ein Bild (Ist-Zustand) von zumindest einem Teil der Prüfungs- und/oder Montagevorrichtung und speziell insbesondere der Montagefläche, insbesondere der Schnittstelle, aufzunehmen und mit einem Soll-Bild (Soll-Zustand) aus einer Datenbank zu vergleichen. Die Soll-Bilder werden beispielsweise außerhalb der Wartung und separat hiervon in einem Lern- oder Konfigurationsverfahren erzeugt und in der Datenbank gespeichert. Die Datenbank ist entweder ein Teil der Vorrichtung, z.B. ein Teil des Roboters oder ein Teil der Montagefläche, oder separat hiervon ausgebildet und dann über eine geeignete Datenverbindung (z.B. das Internet oder ein lokales Netzwerk) mit der Vorrichtung verbunden, sodass diese die Soll-Bilder bei Bedarf abfragt oder umgekehrt die Ist-Bilder zur Verarbeitung an die Datenbank sendet.

In einer vorteilhaften Ausgestaltung ist die Vorrichtung ein selbstlernendes System und weist hierzu eine Lernmaschine auf, welche ausgebildet ist, bei einer jeweiligen Wartung Daten der Prüfungs- und/oder Montagevorrichtung und speziell insbesondere der Montagefläche zu erheben, in einer Datenbank zu speichern und diese Daten bei einer späteren Wartung zu berücksichtigen. Grundsätzlich ist es ausreichend, wenn die Lernmaschine entweder in den Roboter oder in die Montagefläche integriert ist oder sogar als eigenständiges Teil (z.B. als Teil einer externen Datenbank) der Vorrichtung zusätzlich zum Roboter und der Montagefläche ausgebildet ist. Die Lernmaschine kann aber auch auf die verschiedenen Teile der Vorrichtung verteilt sein. Aufgrund der Tatsache, dass die meisten als Schnittstellen verwendeten Komponenten, welche gewartet werden müssen, in größeren Stückzahlen benötigt werden, existiert eine breite Datenbasis, welche für die Nutzung einer Lernmaschine eine vorteilhafte Grundlage bilden, sodass die Vorrichtung fast alle im Rahmen der Wartung anfallenden Wartungsaufgaben selbst bewerten kann. Beispielsweise lernt die Vorrichtung selbsttätig, wann eine Schnittstelle einen Defekt aufweist oder wann eine Reinigung erforderlich ist. Diese Daten werden zweckmäßigerweise in der beschriebenen Datenbank gesammelt und für verschiedene darauf aufbauende Wartungsaufgaben während der Wartung oder sogar noch für andere Anwendungen genutzt. Daraus ergeben sich insbesondere die folgenden, vorteilhaften Ausgestaltungen:
- Erzeugung einer lokalen oder globalen Datensammlung (in der Datenbank) über zu prüfende Montageflächen und/oder einzelne Schnittstellen und deren wartungsspezifische Parametern sowie Sammlung von Ergebnissen der Wartung bis auf Schnittstellenebene.
- Durchführung eines global zentralisierten offline Teachings der Vorrichtung (d.h. Lernverfahren für das selbstlernende System), mit der Möglichkeit, etwaige Änderungen an der Montagefläche mittels bekannter Bilder zu verifizieren, ohne eine direkte Änderung an der laufenden Vorrichtung vorzunehmen, wodurch sich der Bedarf an hoch qualifizierten Fachkräften vorteilhaft reduziert.
- Erstellung verschiedener Reports, z.B. Auswertung von erkannten Defekten, Probleme etc., um darauf aufbauend eine entsprechende Schnittstelle zu optimieren oder auszutauschen; oder Auswertung der Fehlerhäufigkeit und darauf aufbauend eine Optimierung der Wartungsintervalle auf Schnittstellenebene, anstatt diese lediglich auf Grundlage allgemeiner Daten zu planen, sodass die Dauer einer Wartung reduziert wird.

In einer geeigneten Ausgestaltung ist die Vorrichtung ausgebildet, eine Fehlerhäufigkeit (oder analog eine Ausfallwahrscheinlichkeit) der Schnittstelle zu bestimmen, z.B. während einer Lernphase, in welcher das Auftreten von Fehlern (d.h. Defekten, Beschädigungen, Fehlfunktionen etc.) von der Vorrichtung dokumentiert wird. Anhand dessen, d.h. anhand der Fehlerhäufigkeit, legt die Vorrichtung ein Wartungsintervall für die Schnittstelle fest, z.B. wird ein bereits vorhandener Wert für das Wartungsintervall angepasst oder ein Wartungsintervall erstmalig festgelegt. Die Vorrichtung lernt demnach aufgrund des tatsächlichen Verhaltens der Schnittstelle automatisch ein optimales Wartungsintervall, nach welchem die Schnittstelle dann gewartet wird und erkennt somit letztendlich deren tatsächlichen Wartungsbedarf. Dadurch wird eine unnötige Wartung vermieden und Zeit eingespart.

Ein erfindungsgemäßer Roboter ist ausgebildet zur Verwendung in einer Vorrichtung wie vorstehend beschrieben. Ein oder mehrere der Merkmale, welche vorstehend allgemein als Merkmale der Vorrichtung beschrieben wurden, sind geeigneterweise mittels des Roboters realisiert. Dies betrifft speziell, jedoch nicht ausschließlich, diejenigen Merkmale im Zusammenhang mit der Wartung der Montagefläche.

Bei einem erfindungsgemäßen Verfahren zur Wartung einer Vorrichtung wie vorstehend beschrieben, wartet der Roboter die Prüfungs- und/oder Montagevorrichtung und speziell vorzugsweise die Montagefläche automatisch, entweder vollständig selbstständig oder lediglich teilweise und dann zweckmäßigerweise in Ergänzung zu einem Techniker. Das Verfahren ist insgesamt ein Wartungsverfahren, bei welchem dann die Montagefläche z.B. wie beschrieben überprüft und/oder konfiguriert wird.

In einer zweckmäßigen Ausgestaltung des Verfahrens werden die nachfolgenden Schritte ausgeführt, jedoch nicht notwendigerweise in der angegebenen Reihenfolge: Zunächst wird der Roboter vor einer zu wartenden Montagefläche ungefähr an einer festgelegten Stelle platziert und bei Bedarf fixiert, z. B. von einem Techniker. Der Roboter wird dann aktiviert, z.B. indem der Techniker eine Spannungsversorgung des Roboters einschaltet und ihn startet. In einem ersten Schritt des Verfahrens erkennt der Roboter mit Hilfe von einem oder mehreren Sensoren, darunter vorzugsweise eine Kamera, die zu prüfende Montagefläche und seine Position relativ hierzu. Mittels einer Datenbank (z.B. wie oben beschrieben) erstellt der Roboter in einem zweiten Schritt einen Arbeitsablauf für die Wartung, um alle vorab festgelegten Wartungsaufgaben möglichst effektiv abzuarbeiten. Der tatsächliche Wartungsvorgang wird nun gestartet, z.B. durch den Techniker, welcher dann andere und nicht zwingend mit der Wartung zusammenhängende Tätigkeiten wahrnehmen kann. Der Roboter führt nun in einem dritten Schritt alle festgelegten Wartungsaufgaben aus. Dabei wählt und verwendet der Roboter insbesondere jeweils geeignete Werkzeuge oder Hilfsmittel je nach Bedarf, z.B. mittels eines Werkzeugwechselsystems. Nachdem alle Wartungsaufgaben, welche alleinig durch den Roboter durchführbar sind, von diesem abgearbeitet wurden, wird in einem vierten Schritt ein entsprechender Hinweis ausgegeben, z.B. wird der Techniker mittels SMS etc. darüber informiert, dass er/sie zurückkehren soll. In Kooperation mit dem Techniker werden bei Bedarf in einem fünften Schritt komplexere Wartungsaufgaben erledigt, welche sowohl den Techniker als auch den Roboter zur Unterstützung benötigen, z.B. eine Reparatur von Defekten etc. Anschließend werden in einem sechsten Schritt durch den Roboter etwaige zuvor erkannte Fehler erneut überprüft, um eine einwandfreie Wartung und speziell Reparatur sicherzustellen. Schließlich wird der Roboter ausgeschaltet und an die nächste Montagefläche gefahren. Weitere vorteilhafte Ausgestaltungen des Verfahrens ergeben sich durch Auslassen oder Hinzufügen eines oder mehrerer Schritte.

Besondere Vorteile der Lernmaschine sind, dass zeitintensive und wiederkehrende Wartungsaufgaben auf einfache und schnelle Art automatisiert sind, ohne dass dazu in jedem Einzelfall spezifische Lösungen gefunden werden müssen. Durch die Lernmaschine reagiert die Vorrichtung wesentlich flexibler auf Umgebungsänderungen und somit auch auf Änderungen der Wartung. Bei klassischen Ansätzen müssen fast immer schnittstellenspezifische Lösungen gefunden werden, was dazu führt, dass z.B. die gleiche Schnittstelle, welche mehrmals in der Montagefläche vorkommt, aufgrund ihrer Position, Umgebung oder minimal verändertem Aussehen einzeln definiert werden muss. Durch die Lernmaschine wird nun vorteilhaft für alle gleichartigen Schnittstellen eine einzelne Definition genutzt, was den Zeitaufwand für die Wartung (speziell die Konfiguration) drastisch reduziert. Dadurch werden insbesondere bis zu 70% - 80% des Zeitaufwands eines Technikers für die klassische, manuelle Wartung eingespart. Der Techniker wird lediglich zum Einrichten des Roboters benötigt sowie später eventuell zur Behebung von solchen Problemen, welche durch den Roboter allein nicht behebbar sind. Weiterhin werden durch die gesammelten Daten auf Schnittstellenebene (Prüfmodule, Clipsaufnahmen, Steckerhalterungen, Gabeln, Sensoren etc.) die Zeitintervalle der Wartung für die gesamte zu wartende Montagefläche optimiert, was die Verfügbarkeit der Montagefläche für die eigentliche Produktion erhöht, d.h. für die Prüfung und/oder Montage des Kabelsatzes. Durch die vorteilhaft automatisierte Prüfung werden zudem menschliche Einflüsse wesentlich reduziert, woraus sich geringere ungeplante Stillstandszeiten in der laufenden Produktion ergeben sowie eine Reduzierung von anderen Aufwendungen für Nacharbeiten, zusätzlichen Qualitätskontrollen etc. Die insbesondere während einer Vielzahl an Wartungen gesammelten Daten (d.h. historische Daten) werden zweckmäßigerweise für eine Optimierungen der Vorrichtung und deren Montagefläche und Schnittstellen genutzt. Eine solche Optimierung ist besonders effektiv, da die Daten von der Vorrichtung automatisiert gesammelt und geeigneterweise auch klassifiziert werden. Bei manuellen Durchführungen werden schätzungsweise nur 10% - 30% von wiederkehrenden Fehlern, Defekten, Problemen etc. erkannt. Die hier vorgestellte Vorrichtung realisiert demgegenüber eine deutlich vorteilhaftere, automatische Auswertung der Daten sowie eine Überprüfung der damit vorgenommenen Optimierung.

Ein erfindungsgemäßes Computerprogramm umfasst Befehle, welche bewirken, dass eine Vorrichtung wie oben beschrieben die Schritte eines Verfahrens wie oben beschrieben ausführt. Das Computerprogramm wird vorzugsweise auf dem Roboter ausgeführt, welcher hierzu eine geeignete Steuereinheit aufweist.

Die hier vorgestellte Vorrichtung ist abseits des beschriebenen Anwendungsfalls der Wartung der Montagefläche auch für andere häufig wiederkehrende Aufgaben mit ähnlichen Anforderungen vorteilhaft nutzbar, z.B. im Rahmen der tatsächlichen Prüfung und/oder Montage des Kabelsatzes oder bei anderen Montageflächen als den hier angenommenen Testtischen und Montagebrettern.

Nachfolgend werden Ausführungsbeispiele der Erfindung anhand einer Zeichnung näher erläutert. Darin zeigen jeweils schematisch:
Fig. 1 eine Vorrichtung,
Fig. 2 eine Variante der Vorrichtung,
Fig. 3 die Vorrichtung aus Fig. 2 in einer anderen Ansicht,
Fig. 4 eine weitere Variante der Vorrichtung,
Fig. 5 ein Verfahren,
Fig. 6 eine weitere Variante der Vorrichtung.

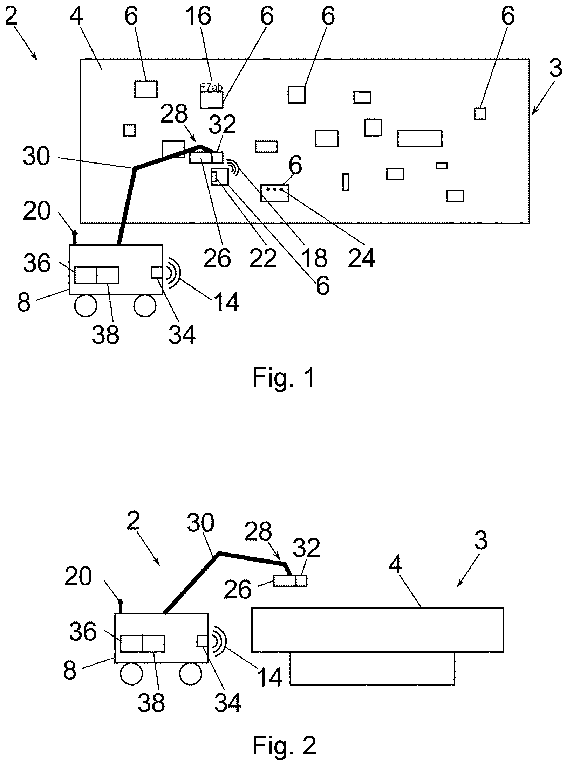

Fig. 1 zeigt in einer Seitenansicht ein Ausführungsbeispiel für eine Vorrichtung 2, welche zur Prüfung und/oder Montage eines nicht explizit gezeigten Kabelsatzes K ausgebildet ist. Die Vorrichtung 2 weist ein Prüfungs- und/oder Montagevorrichtung 3 mit einer Montagefläche 4 auf, welche zumindest eine Schnittstelle 6 aufweist, z.B. ein Prüfmodul, einen Sensor, einen Steckverbinder, eine Gabel, einen Clip, eine Halterung oder dergleichen, um den Kabelsatz K zu prüfen und/oder zu halten. Die Schnittstelle 6 ist beispielsweise eine elektrische, mechanische, hydraulische oder optische Schnittstelle 6 oder eine Kombination hiervon. Typischerweise weist die Montagefläche 4 wie in Fig. 1 erkennbar eine Vielzahl an Schnittstellen 6 auf, um den Kabelsatz K an unterschiedlichen Stellen zu prüfen und/oder zu halten. Weiter weist die Vorrichtung 2 einen Roboter 8 auf, zur automatisierten Wartung der Montagefläche 4, genauer gesagt zur Wartung der Schnittstellen 6. Nachfolgend wird ohne Beschränkung der Allgemeinheit davon ausgegangen, dass die Montagefläche 4 mehrere Schnittstellen 6 aufweist, welche auch nicht zwingend gleichartig ausgebildet sind, die Ausführungen gelten aber auch für eine Montagefläche 4 mit lediglich einer Schnittstelle 6.

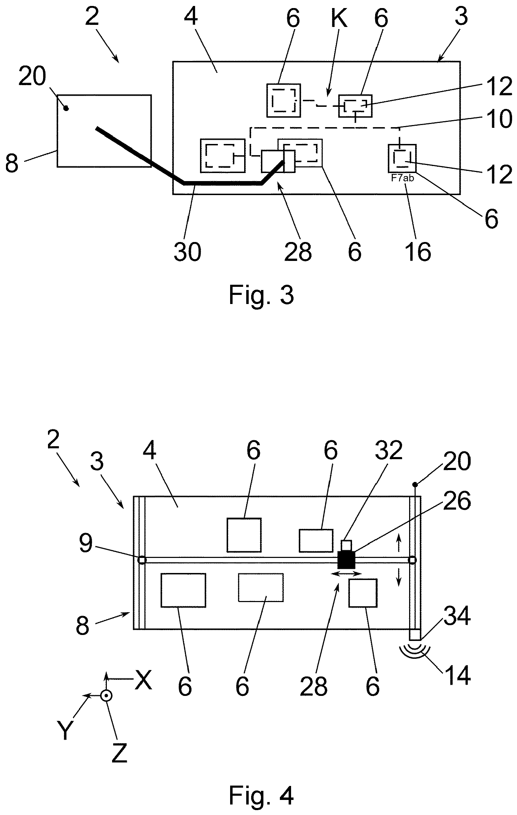

Im Ausführungseispiel der Fig. 1 ist die Montagefläche 4 eine Oberfläche eines Montagebretts. In den Fig. 2 und 3 ist ein anderes Ausführungsbeispiel gezeigt, bei welchem die Montagefläche 4 eine Oberfläche eines Testtisches ist. Dabei zeigt Fig. 2 die Vorrichtung 2 in einer Seitenansicht und Fig. 3 zeigt die gleiche Vorrichtung 2 in einer Draufsicht. In Fig. 3 ist zudem mit gestrichener Linie ein Kabelsatz K angedeutet, dieser ist jedoch nicht tatsächlich präsent. In den Ausführungsbeispielen der Fig. 1 bis 3 ist der Roboter 8 ein Cobot. In Fig. 3 ist dann eine Variante gezeigt, bei welcher der Roboter 8 eine Translationseinheit 9 aufweist, welche mit der Montagefläche 4 verbunden ist und dann einen XYZ-Tisch bildet. Die Montagefläche 4 in Fig. 4 ist identisch mit der Montagefläche in den Fig. 2 und 3. Mischformen von Testtisch und Montagebrett sind grundsätzlich auch möglich. Ebenso ist der Roboter 8 in Fig. 4 grundsätzlich auch mit der Montagefläche in Fig. 1 kombinierbar. Mit anderen Worten: die hier beschriebene Erfindung beschränkt sich nicht auf die explizit gezeigten Kombinationen von Montagefläche 4 und Roboter 8.

Der Kabelsatz K ist zusammengesetzt aus mehreren Kabeln 10 und/oder Leitungen und weist gegebenenfalls zusätzlich noch Medienschläuche, z.B. für Druckluft, oder ähnliches auf. Optional weist der Kabelsatz zusätzlich noch ein oder mehrere Funktionsmodule 12 auf, um anwendungsabhängige Funktionen zu implementieren, z.B. Schalter, Wandler, Sensoren etc. Der Kabelsatz weist geeigneterweise entsprechende Steckverbinder am Ende oder entlang der Kabel 10, Leitungen oder Medienschläuche auf, um den Kabelsatz K in ein nicht explizit gezeigtes Gesamtsystem, z.B. ein Fahrzeug, zu integrieren. Die genaue Ausgestaltung des Kabelsatzes K ist vorliegend von untergeordneter Bedeutung. Tatsächlich ist der Kabelsatz K während der hier beschriebenen Wartung der Montagefläche 4 üblicherweise nicht präsent und spielt für die Wartung nur insofern eine Rolle, als dass der Kabelsatz K die konkrete Ausgestaltung der Montagefläche 4 definiert. Zur Prüfung und/oder Halterung wird der Kabelsatz K mit den Schnittstellen 6 der Montagefläche 4 gekoppelt (z.B. befestigt, gesteckt, geclipst, eingelegt, aufgelegt oder dergleichen).

Die Ausgestaltung und Anordnung der Schnittstellen 6 ist abhängig von der konkreten Ausgestaltung des Kabelsatzes K, die in den Fig. 1 bis 4 gezeigten Anzahlen und Anordnungen sind daher lediglich beispielhaft. Die Schnittstellen 6 sind regelmäßig über die Montagefläche 4 verteilt angeordnet, sodass der Kabelsatz K bei dessen Prüfung/Halterung an verschiedenen Stellen mit der Montagefläche 4 gekoppelt ist.

In einer möglichen Ausgestaltung sind eine oder mehrere der Schnittstellen 6 Halterungen, zum Halten des Kabelsatzes K, und der Roboter 8 ist derart ausgebildet, dass dieser im Rahmen der Wartung die Halterung überprüft. Diese Überprüfung der Halterung stellt eine Wartungsaufgabe dar. Die Halterung realisiert eine mechanische und lösbare Verbindung des Kabelsatzes K mit der Montagefläche 4.

Die Überprüfung der Halterung und allgemein jeglicher Schnittstelle 6 durch den Roboter 8 umfasst allgemein die Erkennung eines Ist-Zustands der Schnittstelle 6 und einen Vergleich des Ist-Zustands mit einem Soll-Zustand sowie die Ausgabe eines Hinweises 14 z.B. an einen Techniker, dass der Ist-Zustand mit dem Soll-Zustand übereinstimmt oder nicht.

Mittels der Überprüfung wird vorliegend ermittelt, ob die jeweilige Schnittstelle 6 ordnungsgemäß beschaffen ist und/oder ordnungsgemäß funktioniert. Auf diese Weise wird vom Roboter 8 beispielsweise eine Beschädigung der Schnittstelle 6 erkannt, z.B. ein Abriss eines Teils der Halterung aufgrund einer unsachgemäßen Handhabung während einer vorangegangenen Montage. Alternativ oder zusätzlich wird vom Roboter 8 überprüft, ob an einer gegebenen Position eine Schnittstelle 6 eines bestimmten Typs installiert ist. Der Typ ist z.B. durch eine Codierung 16 an oder in der Nähe der Schnittstelle 6 angegeben, z.B. eine Farbcodierung oder Beschriftung. Der Roboter 8 erkennt die Codierung 16 (Ist-Zustand) und vergleicht diese mit einer vorgesehenen Codierung 16 (Soll-Zustand). Ist die erkannte Codierung 16 inkorrekt, wird vom Roboter 8 ein entsprechender Hinweis 14 ausgegeben. Alternativ oder zusätzlich wird vom Roboter 8 eine Funktion der Schnittstelle 6 überprüft. In einer möglichen Ausgestaltung gibt die Schnittstelle 6 bei der Kopplung mit einem Kabelsatz K ein Kontrollsignal 18 aus. Um diese Funktion zu prüfen simuliert der Roboter 8 die Kopplung und ist ausgebildet, das Kontrollsignal 18 zu empfangen, z.B. mittels einer Antenne 20. Die Antenne 20 stellt eine Empfangseinheit dar, zum Empfangen eines Kontrollsignals 18. Empfängt der Roboter das Kontrollsignal 18, ist die Funktion korrekt, andernfalls fehlerhaft, woraufhin dann ein entsprechender Hinweis 14 ausgegeben wird.

In einer möglichen Ausgestaltung weist die Schnittstelle 6 einen Schalter 22 auf, welcher durch Koppeln des Kabelsatzes K mit der Schnittstelle 6 auslösbar ist. Der Schalter 22 ist z.B. ein mechanischer, elektrischer oder optischer Schalter, z.B. ein Taster oder Näherungssensor. Bei einer Kopplung mit einem Kabelsatz K löst der Schalter 22 aus und sendet ein Kontrollsignal 18 aus, welches bei der Prüfung und/oder Montage des Kabelsatzes K genutzt wird. Die korrekte Funktionsfähigkeit des Schalters 22, d.h. das Auslösen des Schalters 22 und Aussenden des Kontrollsignals 18 wird nun im Rahmen der Wartung durch den Roboter 8 überprüft. Auch dies stellt eine mögliche Wartungsaufgabe dar. Entsprechend ist der Roboter 8 ausgebildet, im Rahmen der Wartung den Schalter 22 auszulösen und dadurch die Funktionsfähigkeit der Schnittstelle 6 zu überprüfen. Analog zu den Ausführungen weiter oben betätigt der Roboter 8 im Rahmen der Wartung den Schalter 22, d.h. löst diesen aus, und erwartet dann das Kontrollsignal 18. Dieses empfängt der Roboter 8 beispielsweise über die Antenne 20 oder einen anderen Signaleingang. Die Schnittstelle 6 ist beispielsweise eine Halterung oder ein Prüfmodul, welches mittels des Schalters 22 die Anwesenheit eines Kabelsatzes K prüft, speziell die Anwesenheit eines bestimmten Abschnitts oder Funktionsmoduls 12 des Kabelsatzes K. Zur Gewährleistung dieser Funktionalität wird der Schalter 22 vom Roboter 8 während der Wartung betätigt und damit eine Kopplung mit einem korrekt hergestellten Kabelsatz K simuliert.

In einer möglichen Ausgestaltung sind ein oder mehrere Schnittstellen 6 vorhanden, welche jeweils als Prüfmodul ausgebildet sind und mit welchen bei der Prüfung des Kabelsatzes K z.B. dessen Funktionalität im Gesamtsystem simuliert wird. Während der Wartung werden solche Schnittstellen 6 nun durch den Roboter 8 geprüft, indem dieser analog zu obigen Ausführungen die Präsenz eines Kabelsatzes K simuliert und/oder indem der Roboter 8 an der Schnittstelle 6 eine oder mehrere geeignete Messungen vornimmt, um die korrekte Beschaffenheit und/oder Funktionsweise eines jeweiliges Prüfmoduls zu prüfen und gegebenenfalls einen Hinweis 14 auf einen Defekt oder eine Fehlfunktion auszugeben. Auch dies stellt eine Wartungsaufgabe dar.

In einer möglichen Ausgestaltung ist der Roboter 8 ausgebildet, im Rahmen der Wartung eine Konfiguration der Montagefläche 4 zu unterstützen, indem der Roboter 8 die Schnittstelle 6 aktiviert oder identifiziert oder einem Bauteil des Kabelsatzes K oder einem Bauteil eines Gesamtsystems, in welches der Kabelsatz K integriert werden soll, zuordnet oder eine Kombination hiervon. Auch dies stellt eine Wartungsaufgabe dar. Bei dieser Ausgestaltung wird davon ausgegangen, dass die Schnittstellen 6 der Montagefläche 4 vor einer Prüfung/Montage des Kabelsatzes K definiert werden müssen, um eine korrekte Zuordnung von Kontrollsignalen 18 der Schnittstellen 6 zu korrespondierenden Bauteilen des Kabelsatzes K und/oder des Gesamtsystems sicherzustellen. Die Kontrollsignale 18 werden von einem geeigneten Computer oder ähnlichem empfangen, dieser kennt jedoch anfangs noch nicht die Zuordnung der Kontrollsignale 18 zu den Bauteilen. Diese Zuordnung wird nun im Rahmen der Konfiguration (und damit als Teil der Wartung der Montagefläche) mit Hilfe des Roboters 8 erstellt. Dabei dient der Roboter 8 entweder lediglich als Assistenz für einen Techniker, aktiviert beispielsweise die Schnittstellen 6 der Reihe nach, um deren Kontrollsignale 18 auszulösen, während der Techniker am Computer die dort empfangenen Kontrollsignale 18 den entsprechenden Bauteilen zuordnet. Alternativ führt der Roboter 8 die Konfiguration vollständig selbsttätig durch, indem der Roboter 8 einerseits die Schnittstellen 6 nacheinander auslöst und die entsprechenden Kontrollsignale 18 empfängt und zugleich das zugehörige Bauteil identifiziert, z.B. indem eine entsprechende Codierung 16 der Schnittstelle 6 ausgelesen wird, sodass dann der Roboter 8 das Kontrollsignal 18 dem entsprechenden Bauteil zuordnet. Beispielsweise sind Bezeichnungen der Bauteile jeweils als Beschriftung neben einer jeweiligen Schnittstelle 6 angebracht. Der Roboter 8 verknüpft dann die Codierung 16 mit dem Kontrollsignal 18 und führt somit die Konfiguration aus.

In einer möglichen Ausgestaltung weist die Schnittstelle 6 zumindest einen elektrischen Anschluss 24 auf, zum Anschließen des Kabelsatzes K, und der Roboter 8 ist ausgebildet, im Rahmen der Wartung der Montagefläche 4 den elektrischen Anschluss 24 zu Reinigen oder zu Überprüfen oder beides. Auch dies stellt eine mögliche Wartungsaufgabe dar. Der elektrische Anschluss 24 der Schnittstelle 6 dient zum elektrischen Anschließen des Kabelsatzes K. Die Reinigung ist beispielsweise eine mechanische oder chemische Reinigung, in einer möglichen Ausgestaltung umfasst die Reinigung ein Absaugen z.B. von Verschmutzungen und/oder Fremdkörpern.

In einer möglichen Ausgestaltung weist der Roboter 8 einen Sauger (z.B. Vakuumsauger) als Werkzeug 26 auf, zum Reinigen wenigstens eines Teils der Montagefläche im Rahmen der Wartung, z.B. zum Reinigen eines elektrischen Anschlusses einer Schnittstelle wie zuvor bereits im Zusammenhang mit einer mechanischen Reinigung eines elektrischen Anschlusses beschrieben.

Optional weist der Roboter 8 als ein Werkzeug 26 ein Federkraftmessgerät auf, zum Messen einer Federkraft eines elektrischen Anschlusses 24 der Schnittstelle 6 als eine Wartungsaufgabe im Rahmen der Wartung.

Für den Roboter 8 sind besonders die zwei nachfolgend beschriebenen Ausgestaltungen vorteilhaft: in einer ersten Ausgestaltung wie in Fig. 4 gezeigt weist der Roboter 8 einen Arbeitskopf 28 und die bereits Translationseinheit 9 auf, wobei der Arbeitskopf 28 an der Translationseinheit 9 angebracht ist und wobei die Translationseinheit 9 mit der Montagfläche 4 verbunden ist und derart ausgebildet ist, dass mittels der Translationseinheit 9 der Arbeitskopf 28 an unterschiedliche Positionen der Montagefläche 4 bewegbar ist. Der Roboter 8 ist somit ein fester Bestandteil der Vorrichtung 2 und mit der Montagefläche 4 prinzipiell fest verbunden. Die Translationseinheit 9 ist beispielsweise wie in Fig. 4 gezeigt eine dreiachsige Verschiebevorrichtung, z.B. mit drei paarweise senkrechten Translationsachsen nämlich je einer X-, Y- und Z-Achse X, Y, Z, wobei in Fig. 4 die Z-Achse senkrecht zur Zeichnungsebene verläuft und die X- und Y-Achse in der Zeichnungsebene liegen. Entlang der X- und Y-Achsen X, Y wird der Arbeitskopf 28 parallel zur Montagefläche 4 verschoben, eine Verschiebung entlang der Z-Achse Z ändert hingegen den Abstand des Arbeitskopfs 28 zur Montagefläche 4. Am Arbeitskopf 28 sind ein oder mehrere Werkzeuge 26 anbringbar und je nach Wartungsaufgabe während der Wartung angebracht. Beispielsweise weist die Vorrichtung 2 einen nicht explizit gezeigten Werkzeugwechsler und/oder ein Werkzeugdepot auf, mittels welchen am Arbeitskopf 28 je nach Bedarf ein geeignetes Werkzeug 26 angebracht wird. An einer jeweiligen Position ist eine Schnittstelle 6 angeordnet, sodass während der Wartung mit dem Arbeitskopf 28 nacheinander verschiedene Positionen und somit die verschiedenen Schnittstellen 6 angefahren werden, um dort eine Wartung vorzunehmen. Gegebenenfalls wird zwischendurch vom Arbeitskopf 28 ein jeweils geeignetes Werkzeug 26 aufgenommen.

In einer zweiten Ausgestaltung wie in den Fig. 1 bis 3 gezeigt ist der Roboter 8 alternativ ein sogenannter Cobot, welcher insgesamt unabhängig von der Montagefläche 4 positionierbar ist. Zur Wartung der Montagefläche 4 wird der Roboter 8 an diese herangefahren, entweder selbsttätig oder durch einen Techniker. Zweckmäßigerweise weist der Cobot einen Arm 30 mit einem Arbeitskopf 28 wie bereits beschrieben auf, zur Halterung von Werkzeugen 26 und dergleichen.

Vorliegend weist der Roboter 8 eine Kamera 32 auf und ist ausgebildet, mittels der Kamera 32 eine optische Überprüfung oder Identifikation der Schnittstelle 6 durchzuführen oder um seine Position relativ zu der Schnittstelle 6 zu bestimmen, um diese zu warten, oder beides. Die Kamera 32 ist z.B. beweglich am Roboter 8 angebracht, z.B. am Arbeitskopf 28 zusätzlich oder alternativ zu einem Werkzeug 26. Die Kamera 32 dient beispielsweise zur Aufnahme des Ist-Zustands für einen Bildvergleich als Teil einer optischen Überprüfung (z.B. zur Erkennung von Defekten) oder zur Aufnahme eines Bilds der Schnittstelle 6, um darin eine Codierung 16 zu erkennen und somit die Schnittstelle 6 zu identifizieren, wie bereits beschrieben. Beispielsweise identifiziert der Roboter 8 mittels der Kamera 32 einzelne Schnittstellen 6 wie Prüfmodule, Steckeraufnahmen, Sensoren oder andere Bauteile und/oder überprüft diese auf Beschädigungen. Alternativ oder zusätzlich dient die Kamera 32 zur Erkennung eines Aufbaus der Montagefläche 4 oder zur Erkennung der Position der Schnittstellen 6 oder deren Anordnung relativ zueinander. Speziell bei einem Cobot dient die Kamera 32 z.B. zur Ausrichtung des Cobots relativ zur Montagefläche 4, beispielsweise anhand von Justiermarken der Montagefläche 4, welche mit der Kamera 32 erkannt werden, um bestimmte Tätigkeiten während der Wartung auch korrekt ausführen zu können.

Der Roboter 8 weist vorliegend ein Ausgabeelement 34 auf und ist ausgebildet, hierüber einen Hinweis 14 auszugeben, wenn die Wartung abgeschlossen worden ist oder falls während der Wartung ein manuelles Eingreifen erforderlich ist.

Wie bereits angedeutet, ist einer möglichen Ausgestaltung die Vorrichtung 2 ausgebildet, die Montagefläche 4 mittels eines Bildvergleichs zu warten und hierzu ein Bild (Ist-Zustand) von zumindest einem Teil der Montagefläche 4 aufzunehmen und mit einem Soll-Bild (Soll-Zustand) aus einer Datenbank 36 zu vergleichen. Die Soll-Bilder werden beispielsweise außerhalb der Wartung und separat hiervon in einem Lern- oder Konfigurationsverfahren erzeugt und in der Datenbank 36 gespeichert. Die Datenbank 36 ist entweder ein Teil der Vorrichtung 2, z.B. wie in Fig. 1 gezeigt ein Teil des Roboters 8 oder ein Teil der Montagefläche 4 oder separat hiervon ausgebildet und dann über eine geeignete Datenverbindung mit der Vorrichtung 2 verbunden, sodass diese die Soll-Bilder bei Bedarf abfragt oder umgekehrt die Ist-Bilder zur Verarbeitung an die Datenbank 36 sendet.

In einer möglichen Ausgestaltung ist die Vorrichtung 2 ein selbstlernendes System und weist hierzu eine Lernmaschine 38 auf, welche ausgebildet ist, bei einer jeweiligen Wartung Daten der Montagefläche 4 zu erheben, in der Datenbank 36 zu speichern und diese Daten bei einer späteren Wartung zu berücksichtigen. Da die meisten als Schnittstellen 6 verwendeten Komponenten in größeren Stückzahlen benötigt werden, existiert eine breite Datenbasis, welche für die Nutzung einer Lernmaschine 38 eine geeignete Grundlage bilden, sodass die Vorrichtung 2 fast alle im Rahmen der Wartung anfallenden Wartungsaufgaben selbst bewerten kann. Beispielsweise lernt die Vorrichtung 2 selbsttätig, wann eine Schnittstelle 6 einen Defekt aufweist oder wann eine Reinigung erforderlich ist. Diese Daten werden in der Datenbank 36 gesammelt und für verschiedene darauf aufbauende Wartungsaufgaben während der Wartung oder sogar noch für andere Anwendungen genutzt. Daraus ergeben sich insbesondere die folgenden, möglichen Ausgestaltungen:
- Erzeugung einer lokalen oder globalen Datensammlung (in der Datenbank 36) über zu prüfende Montageflächen 4 und/oder einzelne Schnittstellen 6 und deren wartungsspezifische Parametern sowie Sammlung von Ergebnissen der Wartung bis auf Schnittstellenebene.
- Durchführung eines global zentralisierten offline Teachings der Vorrichtung 2 (d.h. Lernverfahren für das selbstlernende System), mit der Möglichkeit, etwaige Änderungen an der Montagefläche 4 mittels bekannter Bilder zu verifizieren, ohne eine direkte Änderung an der laufenden Vorrichtung 2 vorzunehmen.
- Erstellung verschiedener Reports, z.B. Auswertung von erkannten Defekten, Probleme etc., um darauf aufbauend eine entsprechende Schnittstelle 6 zu optimieren oder auszutauschen; oder Auswertung der Fehlerhäufigkeit und darauf aufbauend eine Optimierung der Wartungsintervalle auf Schnittstellenebene.

In einer möglichen Ausgestaltung ist die Vorrichtung 2 ausgebildet, eine Fehlerhäufigkeit (oder analog eine Ausfallwahrscheinlichkeit) einer der Schnittstellen 6 zu bestimmen, z.B. während einer Lernphase, in welcher das Auftreten von Fehlern (d.h. Defekten, Beschädigungen, Fehlfunktionen etc.) von der Vorrichtung 2 dokumentiert wird. Anhand dessen, d.h. anhand der Fehlerhäufigkeit, legt die Vorrichtung 2 ein Wartungsintervall für die Schnittstelle 6 fest, z.B. wird ein bereits vorhandener Wert für das Wartungsintervall angepasst oder ein Wartungsintervall erstmalig festgelegt. Die Vorrichtung 2 lernt demnach aufgrund des tatsächlichen Verhaltens der Schnittstelle 6 automatisch ein optimales Wartungsintervall, nach welchem die Schnittstelle 6 dann gewartet wird und erkennt somit letztendlich deren tatsächlichen Wartungsbedarf.

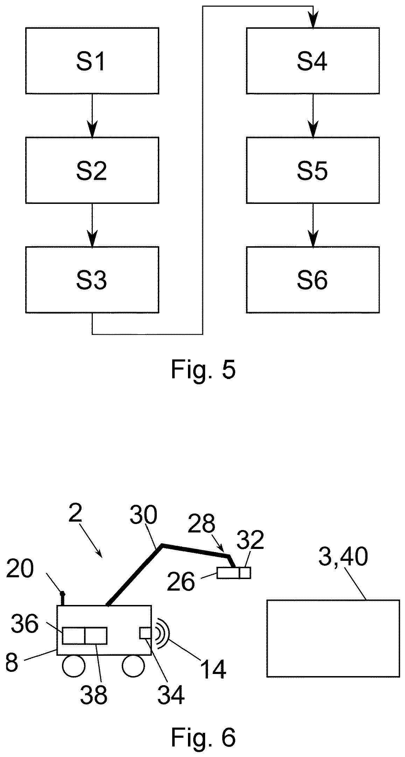

Bei einem Verfahren zur Wartung einer Vorrichtung 2 wie vorstehend beschrieben, wartet der Roboter 8 die Montagefläche 4 automatisch, entweder vollständig selbstständig oder lediglich teilweise und dann z.B. in Ergänzung zu einem Techniker. In Fig. 5 ist eine beispielhafte Ausgestaltung für ein Verfahren gezeigt. Zunächst wird der Roboter 8 vor einer zu wartenden Montagefläche 4 ungefähr an einer festgelegten Stelle platziert und bei Bedarf fixiert, z. B. von einem Techniker. Der Roboter 8 wird dann aktiviert, z.B. indem der Techniker eine Spannungsversorgung des Roboters 8 einschaltet und ihn startet. In einem ersten Schritt S1 des Verfahrens erkennt der Roboter 8 mit Hilfe von einem oder mehreren Sensoren, z.B. mit der Kamera 32, die zu prüfende Montagefläche 4 und seine Position relativ hierzu. Mittels der Datenbank 36 erstellt der Roboter 8 in einem zweiten Schritt S3 einen Arbeitsablauf für die Wartung, um alle vorab festgelegten Wartungsaufgaben möglichst effektiv abzuarbeiten. Der tatsächliche Wartungsvorgang wird nun gestartet, z.B. durch den Techniker, welcher dann andere und nicht zwingend mit der Wartung zusammenhängende Tätigkeiten wahrnehmen kann. Der Roboter 8 führt nun in einem dritten Schritt S3 alle festgelegten Wartungsaufgaben aus. Dabei wählt und verwendet der Roboter 8 jeweils geeignete Werkzeuge 26 oder Hilfsmittel je nach Bedarf, z.B. mittels eines Werkzeugwechselsystems. Nachdem alle Wartungsaufgaben, welche alleinig durch den Roboter 8 durchführbar sind, von diesem abgearbeitet wurden, wird in einem vierten Schritt S4 ein entsprechender Hinweis 14 ausgegeben, z.B. wird der Techniker informiert, dass er/sie zurückkehren soll. In Kooperation mit dem Techniker werden bei Bedarf in einem fünften Schritt S5 komplexere Wartungsaufgaben erledigt, welche sowohl den Techniker als auch den Roboter 8 zur Unterstützung benötigen, z.B. eine Reparatur von Defekten etc. Anschließend werden in einem sechsten Schritt S6 durch den Roboter 8 etwaige zuvor erkannte Fehler erneut überprüft, um eine einwandfreie Wartung und speziell Reparatur sicherzustellen. Schließlich wird der Roboter 8 ausgeschaltet und an die nächste Montagefläche 4 gefahren. Weitere Ausgestaltungen des Verfahrens ergeben sich durch Auslassen oder Hinzufügen eines oder mehrerer Schritte.

Obwohl einige Merkmale lediglich im Zusammenhang mit einem oder nur einem Teil der Ausführungsbeispiele beschrieben wurden, sind diese auch auf andere Ausgestaltungen anwendbar. Generell gilt, dass die im Zusammenhang mit einem bestimmten Ausführungsbeispiel beschriebenen Merkmale grundsätzlich auch einzeln und in beliebiger Kombination anwendbar sind. Das betrifft insbesondere die Ausgestaltung des Roboters 8 und der Montagefläche 4, speziell deren Schnittstellen 6.

In Fig. 6 ist eine Variante der Vorrichtung 2 gezeigt, bei welcher die Prüfungs- und/oder Montagevorrichtung 3 ein Ultraschallschweißgerät 40 ist. Die Ausführungen zu den Fig. 1 - 5 gelten sinngemäß auch für Fig. 6.

### Bezugszeichenliste

- 2: Vorrichtung
- 3: Prüfungs- und/oder Montagevorrichtung
- 4: Montagefläche
- 6: Schnittstelle
- 8: Roboter
- 9: Translationseinheit
- 10: Kabel
- 12: Funktionsmodul
- 14: Hinweis
- 16: Codierung
- 18: Kontrollsignal
- 20: Antenne
- 22: Schalter
- 24: elektrischer Anschluss
- 26: Werkzeug
- 28: Arbeitskopf
- 30: Arm
- 32: Kamera
- 34: Ausgabeelement
- 36: Datenbank
- 38: Lernmaschine
- 40: Ultraschallschweißgerät
- K: Kabelsatz
- S1: erster Schritt
- S2: zweiter Schritt
- S3: dritter Schritt
- S4: vierter Schritt
- S5: fünfter Schritt
- S6: sechster Schritt
- X: X-Achse
- Y: Y-Achse
- Z: Z-Achse

## Patentansprüche

1. Vorrichtung (2) zur Prüfung und/oder Montage eines Kabelsatzes (K),
- mit einer Prüfungs- und/oder Montagevorrichtung (3), wobei die Prüfungs- und/oder Montagevorrichtung (3) eine Montagefläche (4) aufweist, welche zumindest eine Schnittstelle (6) aufweist, um den Kabelsatz (K) zu prüfen und/oder zu halten,
- mit einem Roboter (8), zur Wartung der Prüfungs- und/oder Montagevorrichtung (3).

2. Vorrichtung (2) nach Anspruch 1,
wobei die Prüfungs- und/oder Montagevorrichtung (3) ein Testtisch ist, wobei die Montagefläche (4) eine Oberfläche des Testtisches ist.

3. Vorrichtung (2) nach Anspruch 1 oder 2,
wobei die Schnittstelle (6) eine Halterung ist, zum Halten des Kabelsatzes (K),
wobei der Roboter (8) derart ausgebildet ist, dass dieser im Rahmen der Wartung die Halterung überprüft.

4. Vorrichtung (2) nach einem der Ansprüche 1 bis 3,
wobei die Schnittstelle (6) einen Schalter (22) aufweist, welcher durch Koppeln des Kabelsatzes (K) mit der Schnittstelle (6) auslösbar ist,
wobei der Roboter (8) ausgebildet ist, im Rahmen der Wartung den Schalter (22) auszulösen und dadurch eine Funktionsfähigkeit der Schnittstelle (6) zu überprüfen.

5. Vorrichtung (2) nach einem der Ansprüche 1 bis 4,
wobei die Schnittstelle (6) zumindest einen elektrischen Anschluss (24) aufweist, zum Anschließen des Kabelsatzes (K),
wobei der Roboter (8) ausgebildet ist, den elektrischen Anschluss (24) zu Reinigen oder zu Überprüfen oder beides.

6. Vorrichtung (2) nach einem der Ansprüche 1 bis 5,
wobei der Roboter (8) eine Empfangseinheit aufweist, zum Empfangen eines Kontrollsignals (18), welches während der Wartung von der Schnittstelle (6) ausgesendet wird.

7. Vorrichtung (2) nach einem der Ansprüche 1 bis 6,
wobei der Roboter (8) einen Sauger aufweist,
und/oder
wobei der Roboter (8) ein Federkraftmessgerät aufweist, zum Messen einer Federkraft eines elektrischen Anschlusses (24) der Schnittstelle (6).

8. Vorrichtung (2) nach einem der Ansprüche 1 bis 7,
wobei der Roboter (4) eine Kamera (32) aufweist und ausgebildet ist, mittels der Kamera (32) eine optische Überprüfung oder Identifikation der Schnittstelle (6) durchzuführen und/oder seine Position relativ zu der Schnittstelle (6) zu bestimmen, um diese zu warten.

9. Vorrichtung (2) nach einem der Ansprüche 1 bis 8,
wobei
der Roboter (8) einen Arbeitskopf (28) und eine Translationseinheit (9) aufweist,
der Arbeitskopf (28) an der Translationseinheit (9) angebracht ist, die Translationseinheit (9) derart ausgebildet ist, dass mittels der Translationseinheit (9) der Arbeitskopf (28) an unterschiedliche Positionen der Prüfungs- und/oder Montagevorrichtung (3) bewegbar ist,
oder
wobei der Roboter (8) ein Cobot ist, welcher insgesamt unabhängig von der Prüfungs- und/oder Montagevorrichtung (3) positionierbar ist.

10. Vorrichtung (2) nach einem der Ansprüche 1 bis 9,
wobei diese ausgebildet ist, die Prüfungs- und/oder Montagevorrichtung (3) mittels eines Bildvergleichs zu warten und hierzu ein Bild von zumindest einem Teil der Prüfungs- und/oder Montagevorrichtung (3) insbesondere der Schnittstelle (6), aufzunehmen und mit einem Soll-Bild aus einer Datenbank (36) zu vergleichen.

11. Vorrichtung (2) nach einem der Ansprüche 1 bis 10,
wobei diese ein selbstlernendes System ist und hierzu eine Lernmaschine (38) aufweist, welche ausgebildet ist, bei einer jeweiligen Wartung Daten der Prüfungs- und/oder Montagevorrichtung (3) zu erheben und in einer Datenbank (36) zu speichern und diese Daten bei einer späteren Wartung zu berücksichtigen.

12. Vorrichtung (2) nach einem der Ansprüche 1 bis 11,
wobei diese ausgebildet ist, eine Fehlerhäufigkeit der Schnittstelle (6) zu bestimmen und anhand dessen ein Wartungsintervall für die Schnittstelle (6) festzulegen.

13. Roboter (8), welcher ausgebildet ist zur Verwendung in einer Vorrichtung (2) gemäß einem der Ansprüche 1 bis 12.

14. Verfahren zur Wartung einer Vorrichtung (2) gemäß einem der Ansprüche 1 bis 12, wobei der Roboter (8) die Prüfungs- und/oder Montagevorrichtung (3) automatisch wartet.

15. Computerprogramm, umfassend Befehle, welche bewirken, dass eine Vorrichtung (2) gemäß einem der Ansprüche 1 bis 12 die Schritte eines Verfahrens nach Anspruch 14 ausführt.
